# EUROPÄISCHE PATENTSCHRIFT

(11) **EP 1 745 086 B1**
(45) Veröffentlichungstag und Bekanntmachung des Hinweises auf die Patenterteilung: **28.12.2011**
(21) Anmeldenummer: 05742884.9
(22) Anmeldetag: 10.05.2005
(51) Int. Cl.: C08G 73/00, C08G 61/00, C08G 61/12, C07F 7/00, C07F 7/08, C09K 11/00, C09K 11/06, H01L 51/00, H01L 51/30

(54) **ELEKTROLUMINESZIERENDE POLYMERE**
ELECTROLUMINESCENT POLYMERS
POLYMERES ELECTROLUMINESCENTS

(30) Priorität: 11.05.2004 DE 102004023278
(43) Veröffentlichungstag der Anmeldung: 24.01.2007
(73) Patentinhaber: Merck Patent GmbH, 64293 Darmstadt (DE)
(72) Erfinder: BÜSING, Arne, 65929 Frankfurt (DE); SCHEURICH, René, 64846 Gross-Zimmern (DE); HEUN, Susanne, 65812 Bad Soden (DE); MICHAELSEN, Ingrid, 63225 Langen (DE)
(86) Internationale Anmeldenummer: PCT/EP2005/005020
(87) Internationale Veröffentlichungsnummer: WO 2005/111113

(56) Entgegenhaltungen:
- EP-A- 0 266 693
- EP-A- 1 138 746
- EP-A- 1 245 659
- WO-A-02/077060
- WO-A-03/020790
- WO-A-03/092334
- WO-A-2004/015025
- WO-A-2004/035652
- DE-A1- 3 634 281
- FR-A- 2 655 655
- US-A1- 2003 186 080
- US-A1- 2004 072 018
- US-B1- 6 310 231
- US-B1- 6 558 819
- BAEK N S ET AL: "Temperature effect on photoluminescent properties of red light-emitting materials based on Ru(II)-chelated complexes" PREPARATION AND CHARACTERIZATION, ELSEVIER SEQUOIA, NL, Bd. 417, Nr. 1-2, 30. September 2002 (2002-09-30), Seiten 111-115, XP004387717 ISSN: 0040-6090
- WAI-YEUNG WONG, CHUN-KIN WONG, GUO-LIANG LU, ALBERT WAI-MING LEE, KOK-WAI CHEAH, JIAN-XIN SHI: "Triplet emission in platinum-containing Poly(alkynylsilanes)." MACROMOLECULES, Bd. 36, 2003, Seiten 983-990, XP002337028
- TOKITO S ET AL: "HIGH-EFFICIENCY PHOSPHORESCENT POLYMER LIGHT-EMITTING DEVICES" ORGANIC ELECTRONICS, ELSEVIER, AMSTERDAM, NL, Bd. 4, Nr. 2/3, September 2003 (2003-09), Seiten 105-111, XP001177145 ISSN: 1566-1199

## Beschreibung

Seit ca. 13 Jahren läuft eine breit angelegte Forschung zur Kommerzialisierung von Anzeige- und Beleuchtungselementen auf Basis polymerer (organischer) Leuchtdioden (PLEDs). Ausgelöst wurde diese Entwicklung durch die Grundlagenentwicklungen, welche in WO 90/13148 offenbart sind. Seit kurzem ist auch ein erstes Produkt in Form einer kleineren Anzeige (in einem Rasierapparat der Fa. PHILIPS N.V.) auf dem Markt erhältlich.

Eine Entwicklung, die sich seit einigen Jahren vor allem auf dem Gebiet der "Small molecule"-Displays abzeichnet, ist der Einsatz von Materialien, die aus dem Triplett-Zustand Licht emittieren können und somit Phosphoreszenz statt Fluoreszenz zeigen (M. A. Baldo et al., Appl. Phys. Lett. 1999, 75, 4-6), wodurch eine bis zu vierfache Energie- und Leistungseffizienz möglich ist. Als wesentliche Bedingungen für die praktische Anwendbarkeit sind hier insbesondere ein effizienter Energieübertrag von der Matrix auf den Triplett-Emitter (und damit verbunden effiziente Lichtemission), eine hohe operative Lebensdauer und eine niedrige Betriebsspannung zu nennen.

In letzter Zeit gibt es zunehmend Bemühungen, sich die Vorteile aufdampfbarer Triplett-Emitter auch für Polymeranwendungen zu Nutze zu machen. So werden so genannte Hybrid-Device-Strukturen erwogen, die die Vorteile der "Small-molecule"-OLEDs mit denen der Polymer-OLEDs (= PLEDs) verbinden und durch Mischen des Triplett-Emitters in das Polymer entstehen. Vorteilhafter ist es jedoch, den Triplett-Emitter und eine geeignete Matrix in ein Polymer einzubauen, da dadurch die Gefahr der Phasenseparation bei Deviceherstellung und -betrieb vermieden wird. Beide Methoden haben den Vorteil, dass die Verbindungen aus Lösung verarbeitet werden können und dass kein teurer und aufwändiger Aufdampfprozess wie für Devices auf Basis niedermolekularer Verbindungen erforderlich ist. Das Aufbringen aus Lösung (z. B. durch hochauflösende Druckverfahren) wird langfristig deutliche Vorteile gegenüber dem heute gängigen Vakuum-Verdampfungsprozess aufweisen, v. a. hinsichtlich Skalierbarkeit, Strukturierbarkeit, Beschichtungseffizienz und Ökonomie.
Auch hier ist ein geeignetes Matrixmaterial notwendig, das einen effizienten Energietransfer auf den Triplett-Emitter ermöglicht und das in Verbindung mit diesem gute Lebensdauern bei niedrigen Betriebsspannungen aufweist.

Trotz der in letzter Zeit erzielten Fortschritte gibt es immer noch erhebliches Verbessungspotenzial für entsprechende Materialien auf dem Gebiet der polymeren Triplett-Emitter. U. a. auf folgenden Feldern ist weiterhin ein deutlicher Verbesserungsbedarf zu sehen:
(1) Die Effizienz der Elektrolumineszenzelemente muss noch weiter verbessert werden. Dass prinzipiell eine höhere Effizienz möglich ist, zeigen die Ergebnisse von Elektrolumineszenzelementen auf Basis kleiner Moleküle.
(2) Die Betriebsspannung der Elektrolumineszenzelemente ist noch zu hoch für hochwertige elektronische Anwendungen.
(3) Bislang müssen im Allgemeinen die Matrixmaterialien für bestimmte Triplett-Emitter optimiert werden, so dass ein Matrixmaterial zwar mit einem Triplett-Emitter gute Ergebnisse zeigen kann, aber mit einem anderen Triplett-Emitter, selbst bei vergleichbarer Farbe und insbesondere bei unterschiedlichen Emissionsfarben, deutlich schlechtere Ergebnisse bringt. Hier wäre es wünschenswert, ein Matrixmaterial zur Verfügung zu haben, was mit einer großen Bandbreite an Triplett-Emittern gute Ergebnisse zeigt.
Es ist also offensichtlich, dass auf dem Gebiet polymergebundener Triplett-Emitter und entsprechender geeigneter Matrixmaterialien weiterhin ein großer Verbesserungsbedarf besteht.

N. S. Baek et al. (Thin Solid Films 2002, 417, 111) beschreiben Ruthenium-haltige Organosilan-Polymere als rot emittierende Materialien. Allerdings ist die Intensität der roten Banden bei Raumtemperatur nur schwach wegen nicht-strahlender Relaxation. Erst bei tiefen Temperaturen, die für den üblichen Gebrauch von OLEDs prohibitiv sind, wurden höhere Intensitäten gemessen. Diese Materialien sind also offensichtlich nicht geeignet für die Verwendung in PLEDs, da dort auch bei Raumtemperatur eine hohe Lumineszenzquantenausbeute für eine gute Effizienz nötig ist. Dies legt nahe, dass sich möglicherweise die Kombination von Ruthenium-Komplexen mit Organosilanen nicht für eine effiziente Emission eignet.
Ein ähnliches Ergebnis wird mit Platin(II)-haltigen Silylacetylen-Polymeren beschrieben (W.-Y. Wong et al., J. Chem. Soc., Dalton Trans. 2002, 1587 und W.-Y. Wong et al., Macromolecules, Bd. 36, 2003, 983-990). Hier wird bei tiefer Temperatur eine effiziente blau-grüne Phosphoreszenz beobachtet, während bei Raumtemperatur das Triplett-Exciton durch thermisch aktivierte Diffusion gequencht wird. Auch diese Platin-Silylacetylen-Polymere eignen sich also offensichtlich nicht für effiziente Emission bei Raumtemperatur und sind deshalb auch für die Verwendung in OLEDs nicht geeignet.

In WO 03/092334 sind Polysilane beschrieben, die kovalent gebundene Triplett-Emitter enthalten und sich auch für effiziente blaue Emission eignen sollen. Allerdings sind keinerlei Device-Beispiele angegeben, so dass davon ausgegangen werden muss, dass diese Copolymere das Problem nicht lösen und sich möglicherweise auch nicht für andere Emissionsfarben eignen. Weiterhin sind diese Polymere nicht unproblematisch, da für die Synthese (Wurtz-Synthese) die Umsetzung mit metallischem Natrium notwendig ist, was insbesondere in der technischen Produktion ein Sicherheitsrisiko darstellt und somit in größerem Maßstab nur schwer anwendbar ist.

In der WO 2004/015025 A1 und der US 2004/0072018 A1 werden metallische Komplexe offenbart, die kovalent an konjugierte Polymere gebunden sind, sowie elektronische Vorrichtungen, die diese Verbindungen enthalten.

Licht-emittierende Polymere, die Metall-Komplexe in der Haupt- oder in der Seitenkette aufweisen, werden in der EP 1138746 A1, der EP 1245659 A1 und der US 2003/0186080 A1 offenbart.

Licht-emittierende Polymere, die Metall-Komplexe in der Seitenkette aufweisen, werden von S.Tokito et al. (Organic Electronics, Bd. 4 (2003) 105-111) offenbart.

Konjugierte Polymere, die neben Spirobifluoren-Einheiten bzw. neben Spirobifluoren- und Fluoren-Einheiten noch Metall-Komplexe als Struktureinheiten enthalten, werden in der WO 03/020790 A2 und der WO 02/077060 A1 offenbart.

Polymere, die sowohl aromatische Fluorenyl-Einheiten als auch Silyl-Einheiten aufweisen, werden in der WO 2004/035652 A1 und der US 6,558,819 B1 offenbart.

Blockcopolymere, die Polysilan und organische Polymer-Blöcke enthalten werden in der EP 0266693 A2 offenbart. Elektrisch leitfähige Polysilane werden in der DE 3634281 A1 offenbart. Die Herstellung von speziellen Polymeren, die sowohl Silyl-Einheiten als auch Thiophendiyl-Einheiten enthalten, wird in der FR 2655655 A1 beschrieben.

Spezielle Silan-Verbindungen als Bestandteile von lumineszierenden Vorrichtungen werden in der US 6,310,231 B1 offenbart.

Überraschend wurde gefunden, dass - bisher unbekannte - Copolymere, die bestimmte Organosilaneinheiten und emittierende Iridium-Komplexe kovalent gebunden enthalten, deutliche Verbesserungen im Vergleich zu Polymeren und Mischungen gemäß dem Stand der Technik aufweisen, insbesondere hohe Emissionseffizienz und niedrige Betriebsspannungen. Dies ist insbesondere überraschend, da Organosilan-Polymere mit anderen emittierenden Metallen (Ruthenium, Platin), wie oben beschrieben, bei Raumtemperatur nur zu geringer Phosphoreszenzquantenausbeute führen. Außerdem ist es überraschend, dass die gleiche Polymermatrix hier sowohl für grüne wie auch für rote Triplett-Emitter gute Ergebnisse zeigt. Es ist ein deutlicher technologischer Vorteil, eine Matrix für mehrere oder idealerweise alle Emissionsfarben verwenden zu können, ohne für jeden einzelnen Emitter eine separate Matrix optimieren zu müssen. Diese Copolymere und deren Verwendung in organischen elektronischen Vorrichtungen sind daher Gegenstand der vorliegenden Anmeldung.

Gegenstand der Erfindung sind Copolymere, enthaltend
(A) 1 - 99.99 % mindestens einer Struktureinheit gemäß Formel (1), 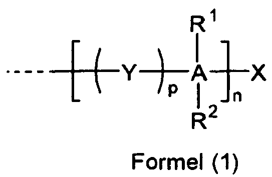 wobei für die verwendeten Symbole und Indizes gilt:
   - A: ist bei jedem Auftreten gleich oder verschieden Si, Ge, Sn oder Pb;
   - Y: ist bei jedem Auftreten gleich oder verschieden ein bivalentes aromatisches oder heteroaromatisches Ringsystem mit 1 bis 40 C-Atomen, das durch einen oder mehrere Reste R⁴ substituiert sein kann, eine Vinylengruppe -CR⁴=CR⁴- oder eine Acetylengruppe -C≡C-;
   - X: ist bei jedem Auftreten gleich oder verschieden eine bivalente Gruppe -(Y)ₚ- (und weist damit eine weitere Verknüpfung mit der Polymerkette auf) oder eine monovalente Gruppe R³;
   - R¹, R², R³: ist bei jedem Auftreten gleich oder verschieden H, F, CN, N(R⁴)₂, eine geradkettige, verzweigte oder cyclische Alkyl-, Alkoxy- oder Thioalkoxygruppe mit 1 bis 40 C-Atomen, die mit R⁴ substituiert oder auch unsubstituiert sein kann, wobei ein oder mehrere nicht benachbarte CH₂-Gruppen durch -R⁵C=CR⁵-, -C≡C-, Si(R⁵)₂, Ge(R⁵)₂, Sn(R⁵)₂, C=O, C=S, C=Se, C=NR⁵, -O-, -S-, -NR⁵- oder -CONR⁵- ersetzt sein können und wobei ein oder mehrere H-Atome durch F, Cl, Br, I, CN, OH oder NO₂ ersetzt sein können, oder ein aromatisches oder heteroaromatisches Ringsystem oder eine Aryloxy- oder Heteroaryloxygruppe mit 2 bis 40 aromatischen C-Atomen, die jeweils durch einen oder mehrere Reste R⁴ substituiert sein können, oder eine Kombination dieser Systeme, wie beispielsweise eine Stilbengruppe, eine Alkylarylgruppe oder eine Tolangruppe; dabei können zwei oder mehrere Substituenten R¹, R² und/oder R³ miteinander ein weiteres mono- oder polycyclisches, aliphatisches oder aromatisches Ringsystem aufspannen;
   - R⁴: ist bei jedem Auftreten gleich oder verschieden H, F, Cl, Br, I, CN, NO₂, eine geradkettige, verzweigte oder cyclische Alkyl- oder Alkoxykette mit 1 bis 22 C-Atomen, in der auch ein oder mehrere nicht benachbarte C-Atome durch -R⁵C=CR⁵-, -C≡C-, Si(R⁵)₂, Ge(R⁵)₂, Sn(R⁵)₂, -NR⁵-, -O-, -S-, -CO-O- oder -O-CO-O- ersetzt sein können, wobei auch ein oder mehrere H-Atome durch F, Cl, Br, I, CN, NO₂ ersetzt sein können, eine Aryl-, Heteroaryl- oder Aryloxygruppe mit 1 bis 40 C-Atomen, welche auch durch ein oder mehrere Reste R⁵ substituiert sein können, oder OH, N(R⁵)₂, B(R⁵)₂ oder Si(R⁵)₃;
   - R⁵: ist bei jedem Auftreten gleich oder verschieden H oder ein aliphatischer oder aromatischer Kohlenwasserstoffrest mit 1 bis 20 C-Atomen;
   - n: ist bei jedem Auftreten gleich oder verschieden 1, 2, 3 oder 4;
   - p: ist bei jedem Auftreten gleich oder verschieden 1, 2 oder 3;
   die gestrichelte Bindung stellt die Anknüpfung an das Polymer dar; sie soll hier keine Methylgruppe bedeuten;
   und
(B) 0.01 - 50 % mindestens eines kovalent gebundenen Iridium-Komplexes, der aus dem Triplett-Zustand Licht emittiert, also Phosphoreszenz statt Fluoreszenz zeigt.

Unter einem aromatischen bzw. heteroaromatischen Ringsystem im Sinne dieser Erfindung soll ein System verstanden werden, das nicht notwendigerweise nur aromatische bzw. heteroaromatische Gruppen enthält, sondern in dem auch mehrere aromatische bzw. heteroaromatische Gruppen durch eine kurze nicht-aromatische Einheit (weniger als 10 % der von H verschiedenen Atome, bevorzugt weniger als 5 % der von H verschiedenen Atome), wie beispielsweise sp³-hybridisierter C, O, N, etc., unterbrochen sein können. So sollen im Sinne dieser Erfindung also beispielsweise auch Systeme wie 9,9'-Spirobifluoren, 9,9-Diarylfluoren, Triarylamin, Diarylether, etc. als aromatische Ringsysteme verstanden werden. Dabei enthält ein aromatisches Ringsystem mindestens 6 C-Atome, während ein heteroaromatisches Ringsystem mindestens 2 C-Atome und mindestens ein Heteroatom, bevorzugt ausgewählt aus N, O und/oder S, enthält und die Summe aus C-Atomen und Heteroatomen mindestens 5 beträgt.

Im Rahmen der vorliegenden Erfindung werden unter einer C₁-bis C₄₀-Alkylgruppe, in der auch einzelne H-Atome oder CH₂-Gruppen durch die oben genannten Gruppen substituiert sein können, besonders bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, n-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden. Unter einer C₁- bis C₄₀-Alkoxygruppe werden besonders bevorzugt Methoxy, Ethoxy, n-Propoxy, i-Propoxy, n-Butoxy, i-Butoxy, s-Butoxy, t-Butoxy oder 2-Methylbutoxy verstanden. Unter einer C₂-C₄₀ Aryl- oder Heteroarylgruppe, die je nach Verwendung monovalent oder bivalent sein kann, die noch jeweils mit den oben genannten Resten R¹ substituiert sein kann und die über beliebige Positionen am Aromaten bzw. Heteroaromaten verknüpft sein kann, werden insbesondere Gruppen verstanden, welche abgeleitet sind von Benzol, Naphthalin, Anthracen, Phenanthren, Pyren, Chrysen, Perylen, Fluoranthen, Tetracen, Pentacen, Benzpyren, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol. Unter aromatischen Ringsystemen werden weiterhin insbesondere Biphenylen, Terphenylen, Fluoren, Spirobifluoren, Dihydrophenanthren, Dihydropyren, Tetrahydropyren oder cis- oder trans-Indenofluoren verstanden.

Die Struktureinheit gemäß Formel (1) kann entweder in die Seitenkette oder in die Hauptkette des Polymers gebunden sein. Steht X für eine monovalente Gruppe R³, so ist die Struktureinheit gemäß Formel (1) in die Seitenkette des Polymers gebunden. Steht X für eine bivalente Gruppe -(Y)p-, so ist die Struktureinheit gemäß Formel (1) in die Hauptkette des Polymers gebunden.

Das erfindungsgemäße Copolymer kann konjugiert, teilkonjugiert oder nichtkonjugiert sein. Bevorzugt ist es konjugiert oder teilkonjugiert.

Konjugierte Polymere im Sinne dieser Erfindung sind Polymere, die in der Hauptkette hauptsächlich sp²-hybridisierte (bzw. auch sp-hybridisierte) Kohlenstoffatome enthalten, die auch durch entsprechende Heteroatome ersetzt sein können. Dies bedeutet im einfachsten Fall abwechselndes Vorliegen von Doppel- und Einfachbindungen in der Hauptkette. Hauptsächlich meint, dass natürlich (ohne weiteres Zutun) auftretende Defekte, die zu Konjugationsunterbrechungen führen, den Begriff "konjugiertes Polymer" nicht entwerten. Des Weiteren wird in diesem Anmeldetext ebenfalls als konjugiert bezeichnet, wenn sich in der Hauptkette Arylamineinheiten, Arylphosphineinheiten und/oder bestimmte Heterocyclen (d. h. Konjugation über N-, O-, S- oder P-Atome) und/oder metallorganische Komplexe, wie beispielsweise Iridium-Komplexe (Konjugation über das Metallatom), befinden. Ebenfalls als konjugiert bezeichnet wird die so genannte σ-Konjugation, also beispielsweise die Konjugation über ein Silicium-Atom. Teilkonjugierte Polymere im Sinne dieser Erfindung sind Polymere, die entweder in der Hauptkette längere konjugierte Abschnitte enthalten, die durch nicht-konjugierte Abschnitte unterbrochen werden, oder die in den Seitenketten eines in der Hauptkette nicht-konjugierten Polymers längere konjugierte Abschnitte enthalten. Hingegen würden Einheiten, wie beispielsweise einfache Alkylenketten, (Thio)Etherbrücken, Ester-, Amid- oder Imidverknüpfungen eindeutig als nicht-konjugierte Segmente definiert.

Die erfindungsgemäßen Copolymere können außer den Einheiten gemäß Formel (1) und außer dem Iridium-Komplex verschiedene weitere Strukturelemente enthalten. Diese können unter anderem Struktureinheiten sein, die das Polymergrundgerüst bilden können, oder Struktureinheiten, die die Ladungsinjektions- bzw. Ladungstransporteigenschaften beeinflussen. Solche Einheiten sind beispielsweise in WO 03/020790 und WO 05/014689 ausführlich beschrieben.

Die erfindungsgemäßen Copolymere können statistische, alternierende oder auch blockartige Strukturen aufweisen oder auch mehrere dieser Strukturen abwechselnd besitzen. Ebenso können die Polymere linear, verzweigt oder dendritisch aufgebaut sein. Durch das Verwenden mehrerer verschiedener Strukturelemente können Eigenschaften, wie z. B. Löslichkeit, Festphasenmorphologie, etc., eingestellt werden. Bevorzugt sind die Polymere linear aufgebaut.

Das Molekulargewicht M_{w} der Polymere liegt zwischen 10³ und 10⁷ g/mol, bevorzugt zwischen 10⁴ und 10⁶ g/mol, besonders bevorzugt zwischen 5 ·10⁴ und 8 ·10⁵ g/mol.

Die erfindungsgemäßen Polymere werden durch Polymerisation entsprechender Monomere hergestellt, wobei mindestens ein Monomer im Polymer zu Einheiten gemäß Formel (1) führt und mindestens ein Monomer den Iridium-Komplex bzw. einen Liganden zur Koordination von Iridium beinhaltet. Insbesondere für die Synthese konjugierter Polymere haben sich hier einige Typen bewährt, die alle zu C-C-Verknüpfungen (SUZUKI-Kupplung, YAMAMOTO-Kupplung, STILLE-Kupplung) führen. Wie die Polymerisation nach diesen Methoden durchgeführt werden kann und wie die Polymere dann vom Reaktionsmedium abgetrennt und aufgereinigt werden können, ist beispielsweise im Detail in WO 04/037887 beschrieben. Eine Methode zur Bildung von Silicium-Aryl-Bindungen ist in US 2003/0120124 beschrieben und besteht in der Reaktion von Aryldiazonium-Salzen mit substituierten Chlorsilanen.
Nach diesen Methoden kann auch die Synthese teilkonjugierter oder nichtkonjugierter Polymere durchgeführt werden, indem entsprechende Monomere verwendet werden, die nicht durchgängig konjugiert sind. Für teilkonjugierte oder nicht-konjugierte Polymere kommen aber auch andere Synthesemethoden in Frage, wie sie allgemein aus der Polymerchemie geläufig sind, wie beispielsweise allgemein Polykondensationen oder kationische, anionische oder radikalische Polymerisationen, die beispielsweise über die Reaktion von Alkenen ablaufen und zu Polyethylen-Derivaten im weitesten Sinne führen, die die funktionellen Einheiten (Silan-Einheiten, Iridium-Komplexe) in den Seitenketten gebunden enthalten.
Bei der Synthese der Polymere kann es bevorzugt sein, wenn der entsprechend substituierte Iridium-Komplex direkt als Monomer eingesetzt wird. Es kann aber auch bevorzugt sein, einen entsprechend substituierten Liganden in der Polymerisationsreaktion einzusetzen und die Komplexierung des Iridiums am fertig aufgebauten Polymer durchzuführen.

In einer bevorzugten Ausführungsform der Erfindung ist A bei jedem Auftreten gleich oder verschieden Si oder Ge, besonders bevorzugt Si.

In einer weiteren bevorzugten Ausführungsform der Erfindung ist Y bei jedem Auftreten gleich oder verschieden ein aromatisches Ringsystem mit 2 bis 25 C-Atomen, das durch einen oder mehrere Reste R⁴ substituiert sein kann, eine Vinylengruppe -CR⁴=CR⁴- oder eine Acetylengruppe -C≡C-, mit der Maßgabe, dass eine Vinylgruppe oder eine Acetylengruppe nur an ein aromatisches System gebunden sein kann; besonders bevorzugt ist Y bei jedem Auftreten gleich oder verschieden gleich oder verschieden ein aromatisches Ringsystem mit 2 bis 16 C-Atomen oder Spirobifluoren, das jeweils durch einen oder mehrere Reste R⁴ substituiert sein kann.

In einer weiteren bevorzugten Ausführungsform der Erfindung ist R¹, R², R³ wie oben definiert, wobei an jeder Struktureinheit gemäß Formel (1) mindestens einer der Substituenten R¹ bis R³ ein aromatisches oder heteroaromatisches Ringsystem mit 2 bis 25 C-Atomen darstellt, das mit einem oder mehreren Substituenten R⁴ substituiert sein kann; besonders bevorzugt ist jeder der Reste R¹, R² und R³ bei jedem Auftreten gleich oder verschieden ein aromatisches oder heteroaromatisches Ringsystem mit 2 bis 16 C-Atomen oder Spirobifluoren, das jeweils mit einem oder mehreren Substituenten R⁴ substituiert sein kann.

In einer weiteren bevorzugten Ausführungsform der Erfindung ist der Index n gleich oder verschieden bei jedem Auftreten 1, 2 oder 3, besonders bevorzugt 1 oder 2.

In einer weiteren bevorzugten Ausführungsform der Erfindung ist der Index p gleich oder verschieden bei jedem Auftreten 1 oder 3, besonders bevorzugt 1.

Weiterhin gilt für bevorzugte Einheiten gemäß Formel (1), dass sie symmetrisch aufgebaut sind. Diese Bevorzugung ist aus der leichteren synthetischen Zugänglichkeit der Verbindungen zu begründen. Für X = Y (Einbau der Einheiten gemäß Formel (1) in die Hauptkette) gilt also bevorzugt, dass alle Y gleich zu wählen sind und dass R¹ = R² ist. Für X = R³ (Einbau der Einheiten gemäß Formel (1) in die Seitenkette) gilt bevorzugt, dass R¹ = R² = R³ ist.

Beispiele für bevorzugte Einheiten gemäß Formel (1) sind substituierte oder unsubstituierte Strukturen gemäß den abgebildeten Beispielen (1) bis (27), wobei die gestrichelten Bindungen eine Verknüpfung im Polymer bedeuten; dabei sind die Beispiele (1) bis (15) Beispiele für Struktureinheiten gemäß Formel (1), die in die Hauptkette gebunden sind; Beispiele (16) bis (27) sind Beispiele für Struktureinheiten gemäß Formel (1), die in die Seitenkette gebunden sind. Alkyl steht für eine geradkettige, verzweigte oder cyclische Alkylkette, die substituiert oder unsubstituiert sein kann, wie für R¹, R², R³ definiert. Potenzielle Substituenten sind wegen der besseren Übersichtlichkeit in der Regel nicht abgebildet.

| | | |
|---|---|---|
| 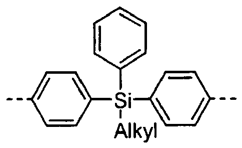 | 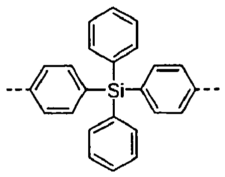 | 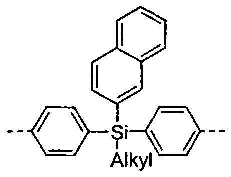 |
| Beispiel 1 | Beispiel 2 | Beispiel 3 |
| 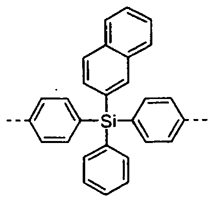 | 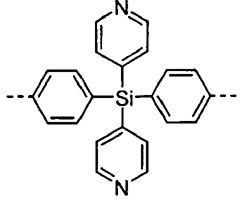 | 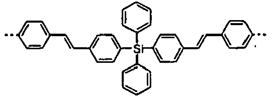 |
| Beispiel 4 | Beispiel 5 | Beispiel 6 |
| 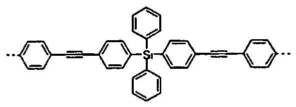 | 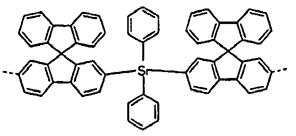 | 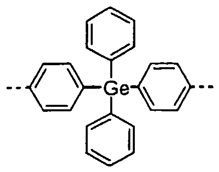 |
| Beispiel 7 | Beispiel 8 | Beispiel 9 |
| 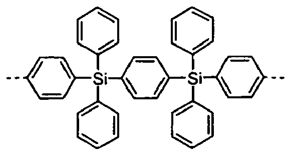 | 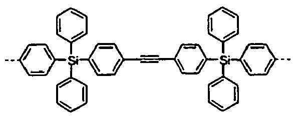 | 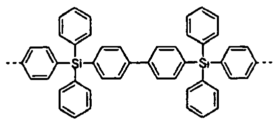 |
| Beispiel 10 | Beispiel 11 | Beispiel 12 |
| 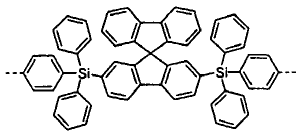 | 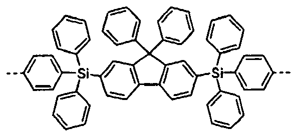 | 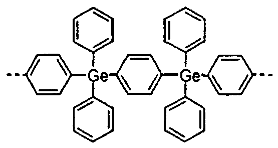 |
| Beispiel 13 | Beispiel 14 | Beispiel 15 |
| 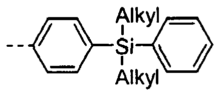 | 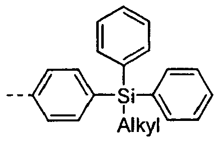 | 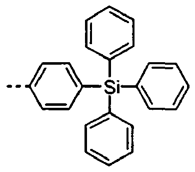 |
| Beispiel 16 | Beispiel 17 | Beispiel 18 |
| 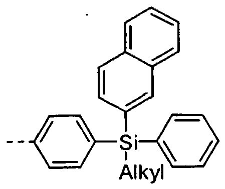 | 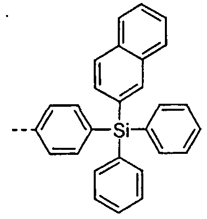 | 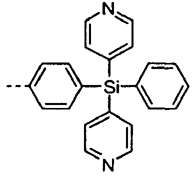 |
| Beispiel 19 | Beispiel 20 | Beispiel 21 |
| 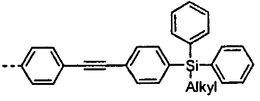 | 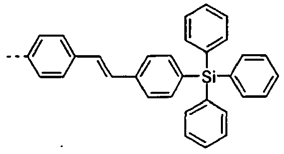 | 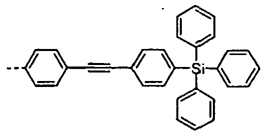 |
| Beispiel 22 | Beispiel 23 | Beispiel 24 |
| 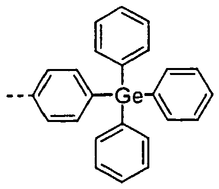 | 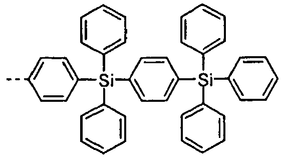 | 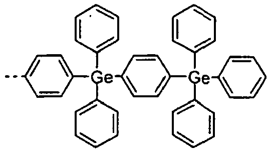 |
| Beispiel 25 | Beispiel 26 | Beispiel 27 |

Auch wenn dies aus der Beschreibung hervorgeht, sei hier nochmals explizit darauf verwiesen, dass die Struktureinheiten gemäß den Beispielen (1) bis (27) auch unsymmetrisch substituiert sein können, d. h. dass an einer Einheit unterschiedliche Substituenten R⁴ vorhanden sein können, bzw. diese auch an unterschiedliche Positionen gebunden sein können. Bei prochiralen Struktureinheiten sind alle Möglichkeiten der Taktizität mit erfasst.

Es hat sich gezeigt, dass ein Anteil im Bereich von 1 - 99.99 mol% Struktureinheiten gemäß Formel (1) (bezogen auf alle Wiederholeinheiten im Polymer) gute Ergebnisse erzielt. Bevorzugt ist ein Anteil von 5-80 mol% Wiederholeinheiten gemäß Formel (1), besonders bevorzugt ist ein Anteil von 10-50 mol% Wiederholeinheiten gemäß Formel (1).

Die im Copolymer gebundenen Iridium-Komplexe sind bevorzugt metallorganische Komplexe, die bei Raumtemperatur aus dem Triplett-Zustand Licht emittieren können. Ohne an eine spezielle Theorie gebunden sein zu wollen, werden im Sinne dieser Anmeldung alle emittierenden Iridium-Komplexe als Triplett-Emitter bezeichnet. Unter einer metallorganischen Verbindung soll eine Verbindung verstanden werden, die mindestens eine direkte Metall-Kohlenstoff-Bindung aufweist. Weiterhin bevorzugt handelt es sich um neutrale Iridium-Komplexe, insbesondere um neutrale Iridium(III)-Komplexe.

Bevorzugt enthalten die Iridium-Komplexe nur chelatisierende Liganden, d. h. Liganden, die über mindestens zwei Bindungsstellen an das Iridium koordinieren; besonders bevorzugt ist die Verwendung von drei zweizähnigen Liganden, die gleich oder verschieden sein können. Die Bevorzugung chelatisierender Liganden lässt sich durch die höhere Stabilität von Chelatkomplexen begründen. Dabei weist der Iridium-Komplex bevorzugt eine Struktur gemäß Formel (2) auf: 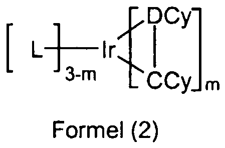 wobei R⁵ wie oben definiert ist und für die weiteren verwendeten Symbole gilt:
- DCy: ist bei jedem Auftreten gleich oder verschieden eine cyclische Gruppe, die mindestens ein Donoratom, bevorzugt Stickstoff oder Phosphor, enthält, über welches die cyclische Gruppe an das Iridium gebunden ist, und die wiederum einen oder mehrere Substituenten R⁶ tragen kann; die Gruppen DCy und CCy sind über eine kovalente Bindung mit einander verbunden;
- CCy: ist bei jedem Auftreten gleich oder verschieden eine cyclische Gruppe, die mindestens ein Kohlenstoffatom enthält, über welches die cyclischen Gruppe an das Iridium gebunden ist, und die wiederum einen oder mehrere Substituenten R⁶ tragen kann;
- L: ist bei jedem Auftreten gleich oder verschieden ein zweizähnig chelatisierender Ligand;
- R⁶: ist bei jedem Auftreten gleich oder verschieden H, F, Cl, Br, I, NO₂, CN, eine geradkettige oder verzweigte oder cyclische Alkyl- oder Alkoxygruppe mit 1 bis 40 C-Atomen, wobei ein oder mehrere nicht benachbarte CH₂-Gruppen durch C=O, C=S, C=Se, C=NR⁵, -R⁵C=CR⁵-, -C≡C-, -O-, -S-, -NR⁵-, Si(R⁵)₂ oder -CONR⁵- ersetzt sein können und wobei ein oder mehrere H-Atome durch F, Cl, Br, I, CN, NO₂ ersetzt sein können, oder ein aromatisches oder heteroaromatisches Ringsystem mit 2 bis 40 C-Atomen, das durch einen oder mehrere, nicht-aromatische Reste R⁶ substituiert sein kann; dabei können mehrere Substituenten R⁶, sowohl am selben Ring als auch an den beiden unterschiedlichen Ringen zusammen wiederum ein weiteres mono- oder polycyclisches, aliphatisches oder aromatisches Ringsystem aufspannen;
- m: ist bei jedem Auftreten 1, 2 oder 3, bevorzugt 2 oder 3, besonders bevorzugt 3;
dabei erfolgt die Anknüpfung an das Polymer entweder über einen oder über mehrere Liganden, bevorzugt über einen oder zwei Liganden.

Bevorzugte Liganden L sind monoanionische Liganden, wie 1,3-Diketonate abgeleitet von 1,3-Diketonen, wie z. B. Acetylaceton, Benzoylaceton, 1,5-Diphenylacetylaceton, Dibenzoylmethan, Bis(1,1,1-trifluoracetyl)methan, 3-Ketonate abgeleitet von 3-Ketoestern, wie z. B. Acetessigsäureethylester, Carboxylate abgeleitet von Aminocarbonsäuren, wie z. B. Pyridin-2-carbonsäure, Chinolin-2-carbonsäure, Glycin, Dimethylglycin, Alanin, Dimethylaminoalanin, oder Salicyliminate abgeleitet von Salicyliminen, wie z. B. Methylsalicylimin, Ethylsalicylimin, Phenylsalicylimin.

Bevorzugt sind ebenfalls mehrkernige Iridium-Komplexe und Iridium-Cluster.

Der Iridium-Komplex wird kovalent in die Polymerkette eingebaut. Um den Einbau des Komplexes in das Polymer zu ermöglichen, müssen am Komplex funktionelle polymerisierbare Gruppen vorhanden sein. Beispiele für entsprechende bromierte Komplexe, die als Monomere in Polykondensationsreaktionen (beispielsweise gemäß SUZUKI oder gemäß YAMAMOTO) eingesetzt werden können, werden in WO 02/068435 und in der nicht offen gelegten Anmeldung DE 10350606.3 beschrieben.

Es hat sich gezeigt, dass ein Anteil von insbesondere 1-25 mol% des Iridium-Komplexes gute Ergebnisse zeigt, wobei sich die Angaben auf die gesamt vorhandenen Wiederholeinheiten im Polymer beziehen.

Es kann auch bevorzugt sein, dem Polymer noch weitere konjugierte, teilkonjugierte oder nicht-konjugierte Polymere, Oligomere, Dendrimere oder weitere niedermolekulare Verbindungen beizumischen. Die Zugabe weiterer Komponenten kann sich für manche Anwendungen als sinnvoll erweisen: So kann beispielsweise durch Zugabe einer elektronisch aktiven Substanz die Loch- bzw. Elektroneninjektion oder der Loch- bzw. Elektronentransport im entsprechenden Blend reguliert werden. Die Zusatzkomponente kann auch den Singulett-Triplett-Transfer verbessern oder selber Licht emittieren. Jedoch auch die Zugabe elektronisch inerter Verbindungen kann hilfreich sein, um beispielsweise die Viskosität einer Lösung oder die Morphologie des gebildeten Films zu kontrollieren. Die so erhaltenen Blends sind ebenfalls Gegenstand der Erfindung.

Die erfindungsgemäßen Copolymere weisen gegenüber dem Stand der Technik folgende überraschende Vorteile auf:
- Die Effizienz der Lichtemission des Iridium-Komplexes ist in erfindungsgemäßen Copolymeren besser im Vergleich zu Copolymeren und Mischungen gemäß dem Stand der Technik.
- Die Betriebsspannungen der OLED werden im Vergleich zum Stand der Technik gesenkt.
- Es werden gute Ergebnisse mit einer großen Bandbreite an unterschiedlichen roten und grünen Triplett-Emittern erhalten. Dies ist ein überraschendes Ergebnis, da bislang immer die Kombination bestimmter Triplett-Emitter mit bestimmten Matrixmaterialien einzeln optimiert werden musste.
- Die Polymere sind sehr gut löslich und lassen sich daher auch sehr gut aus Lösung verarbeiten.

Gegenstand der Erfindung sind weiterhin Lösungen und Formulierungen aus einem oder mehreren erfindungsgemäßen Copolymeren oder Blends in einem oder mehreren Lösungsmitteln. Wie Polymerlösungen hergestellt werden können, ist beispielsweise in WO 02/072714, in WO 03/019694 und in der darin zitierten Literatur beschrieben. Diese Lösungen können verwendet werden, um dünne Polymerschichten herzustellen, zum Beispiel durch Flächenbeschichtungsverfahren (z. B. Spin-coating) oder Druckverfahren (z.B. InkJet Printing).

Die erfindungsgemäßen Copolymere können in PLEDs verwendet werden, insbesondere als Elektrolumineszenzmaterialien (= emittierende Materialien). Für den Bau von PLEDs wird in der Regel ein allgemeines Verfahren verwendet, das entsprechend für den Einzelfall anzupassen ist. Ein solches Verfahren wurde beispielsweise in WO 04/037887 ausführlich beschrieben.

Gegenstand der Erfindung ist daher auch die Verwendung eines erfindungsgemäßen Copolymers in einer PLED als Elektrolumineszenzmaterial.

Gegenstand der Erfindung ist ebenfalls eine PLED mit einer oder mehreren Schichten, wobei mindestens eine dieser Schichten mindestens ein erfindungsgemäßes Copolymer enthält.

Im vorliegenden Anmeldetext und in den folgenden Beispielen wird auf die Verwendung erfindungsgemäßer Copolymere in Bezug auf PLEDs und die entsprechenden Displays abgezielt. Trotz dieser Beschränkung der Beschreibung ist es für den Fachmann ohne weiteres erfinderisches Zutun möglich, die erfindungsgemäßen Polymere auch für weitere Verwendungen in anderen elektronischen Devices (Vorrichtungen) zu benutzen, z. B. für organische Solarzellen (O-SCs), nicht-lineare Optik, Frequenzverdopplung (Upconversion), organische optische Detektoren, organische Feld-Quench-Devices (O-FQDs) oder auch organische Laserdioden (O-Laser), um nur einige Anwendungen zu nennen. Auch diese sind Gegenstand der vorliegenden Erfindung.

Die Erfindung wird durch die nachfolgenden Beispiele näher erläutert, ohne sie dadurch einschränken zu wollen.

### Beispiele

### Beispiel 1: Synthese von Herstellung von 4,4'-Dibromtetraphenylsilan (Monomer Si1)

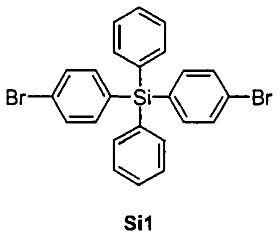

In einem ausgeheizten 1000 mL Vierhalskolben mit Innenthermometer, Rührkern, Argon-Überlagerung und Tropftrichter wurden 33.9 g (144 mmol) 1,4-Dibrombenzol in 300 mL absolutem THF gelöst und auf-75°C gekühlt. Es wurden 90 mL (144 mmol) n-Butyllithium (1.6 M in Hexanfraktion) innerhalb von 30 Minuten zugetropft, anschließend wurde 1 h bei dieser Temperatur gerührt. Dann wurden bei -75 °C 15.3 mL (18.3 g, 72 mmol) Diphenyldichlorsilan in 60 mL THF zugetropft und über Nacht auf Raumtemperatur aufgewärmt. Das Lösemittel wurde entfernt, der Rückstand in Dichlormethan suspendiert und filtriert. Das Lösemittel wurde vom Filtrat entfernt, und das Produkt wurde zweimal aus Butanol und zweimal aus Heptan/Toluol umkristallisiert. Man erhielt 16.8 g (47 % d. Th.) in einer Reinheit von 99.9 % gemäß HPLC.
¹H-NMR (CDCl₃): [ppm] = 7.51 (m, 8H), 7.55 (t, ³J_{HH} = 7.7 Hz, 2H), 7.38 (m, 8H).

### Beispiel 2: Synthese der Iridium-Monomere

Die Synthese der verwendeten Iridium-Monomere ist in der nicht offen gelegten Anmeldung DE 10350606.3 beschrieben. Die im Folgenden verwendeten Iridium-Monomere **Ir1** und **Ir2** seien hier der Übersichtlichkeit halber nochmals abgebildet:

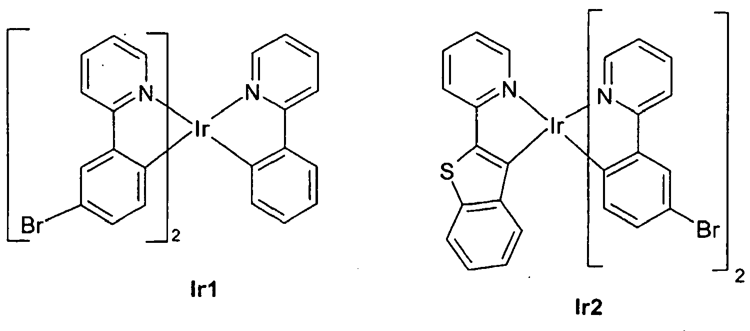

### Beispiel 3: Synthese weiterer Co-Monomere

Die Synthese der weiteren verwendeten Co-Monomere ist in WO 02/077060 und der darin zitierten Literatur ausführlich beschrieben. Das im Folgenden verwendete Monomer **M1** sei hier der Übersichtlichkeit halber nochmals abgebildet:

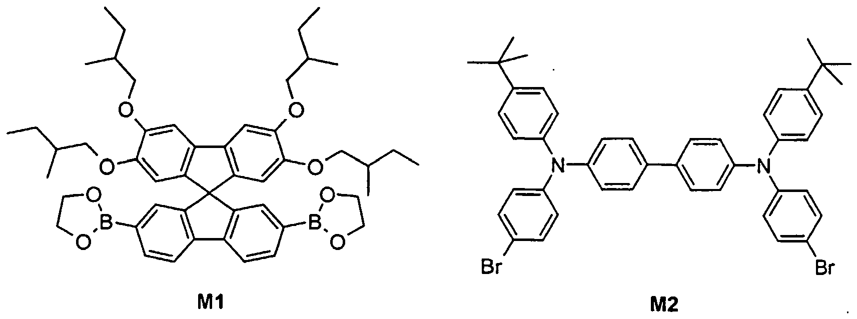

### Beispiel 4: Synthese des erfindungsgemäßen Copolymers P1

1,601 g **M1**, 0,889 g **Si1**, 0,162 g **Ir1** und 2.010 g K₃PO₄·H₂O wurden in 25 mL einer Mischung aus Dioxan und Toluol (3:1) 30 min bei 40°C entgast, anschließend auf 95°C erhitzt und mit 0.5 mL einer 0.05 %igen Lösung aus Pd(OAc)₂ und P(o-Tol)₃ versetzt. Nach 6 h unter Rückfluss wurde auf 65 °C abgekühlt und mit 10 mL N,N-Diethyldithiocarbamidlösung 4 h gerührt. Nach Phasentrennung wurde die organische Phase mit Wasser gewaschen. Das Polymer wurde durch Eintropfen in die doppelte Menge Methanol gefällt und in Toluol gelöst. Nach Filtration durch Celite wurde erneut mit Methanol gefällt und das Polymer im Vakuum getrocknet. Die Ausbeute betrug 1.29 g (60 % d.Th.), das Molekulargewicht Mₙ = 29000 g/mol und M_{w} = 177000 g/mol (GPC in THF mit Polystyrol-Standard).

Weitere erfindungsgemäße Polymere (Polymere **P2**, **P3** und **P4**) wurden gemäß der Synthese von Polymer **P1** hergestellt.

### Beispiel 5: Herstellung der polymeren Leuchtdioden (PLEDs)

Wie PLEDs dargestellt werden können, ist in WO 04/037887 und der darin zitierten Literatur ausführlich beschrieben.

### Beispiele 6 bis 9: Device-Beispiele

Alle hergestellten Polymere wurden auch in PLEDs untersucht. Die Zusammensetzung der Polymere ebenso wie die Ergebnisse in der Elektrolumineszenz (gemessen bei Raumtemperatur, 25°C) sind in Tabelle 1 zusammengefasst.

**Tabelle 1: Einige Deviceergebnisse mit erfindungsgemäßen Copolymeren**

| Beispiel | Polymer | Si-Monomer | Ir-Monomer | sonst. Monomer | Max. Eff. / cd/A | U @100 cd/m²/V | CIE x/y^{a} | Lebensdauer (100)^{b} |
|---|---|---|---|---|---|---|---|---|
| Beispiel 6 | **P1** | 45% **Si1** | 5% **Ir1** | 50% **M1** | 7.2 | 9.9 | 0.51/0.48 | 7 hrs |
| Beispiel 7 | **P2** | 45% **Si1** | 5% **Ir2** | 50% **M1** | 7.7 | 7.2 | 0.60/0.40 | 65 hrs |
| Beispiel 8 | **P3** | 49% **Si1** | 1% **Ir2** | 50% **M1** | 4.8 | 8.4 | 0.61/0.39 | 42 hrs |
| Beispiel 9 | **P4** | 35% **Si1** | 5% **Ir2** | 50% **M1**, 10% **M2** | 3.7 | 6.5 | 0.60/0.39 | 41 hrs |

| | | | | | | | | |
|---|---|---|---|---|---|---|---|---|
| ^{a} CIE-Koordinaten: Chromatizitäts-Koordinaten der Commission Internationale de l'Eclairage von 1931 ^{b} Die Lebensdauer wurde mit einem Beschleunigungsfaktor von 2 auf eine einheitliche Anfangsleuchtdichte von 100 cd/m² extrapoliert. | | | | | | | | |

## Patentansprüche

1. Copolymere, enthaltend
(A) 1 - 99.99 mol% mindestens einer Struktureinheit gemäß Formel (1), 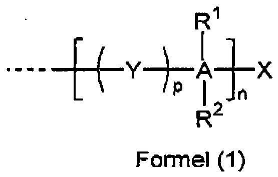 wobei für die verwendeten Symbole und Indizes gilt:
A ist bei jedem Auftreten gleich oder verschieden Si, Ge, Sn oder Pb;
Y ist bei jedem Auftreten gleich oder verschieden ein bivalentes aromatisches oder heteroaromatisches Ringsystem mit 1 bis 40 C-Atomen, das durch einen oder mehrere Reste R⁴ substituiert sein kann, eine Vinylengruppe -CR⁴=CR⁴- oder eine Acetylengruppe -C≡C-;
X ist bei jedem Auftreten gleich oder verschieden eine bivalente Gruppe -(Y)ₚ- oder eine monovalente Gruppe R³;
R¹, R², R³ ist bei jedem Auftreten gleich oder verschieden H, F, CN, N(R⁴)₂, eine geradkettige, verzweigte oder cyclische Alkyl-, Alkoxy- oder Thioalkoxygruppe mit 1 bis 40 C-Atomen, die mit R⁴ substituiert oder auch unsubstituiert sein kann, wobei ein oder mehrere nicht benachbarte CH₂-Gruppen durch -R⁵C=CR⁵-, -C≡C-, Si(R⁵)₂, Ge(R⁵)₂, Sn(R⁵)₂, C=O, C=S, C=Se, C=NR⁵, -O-, -S-, -NR⁵- oder -CONR⁵- ersetzt sein können und wobei ein oder mehrere H-Atome durch F, Cl, Br, I, CN, OH oder NO₂ ersetzt sein können, oder ein aromatisches oder heteroaromatisches Ringsystem oder eine Aryloxy- oder Heteroaryloxygruppe jeweils mit 2 bis 40 aromatischen C-Atomen, die jeweils durch einen oder mehrere Reste R⁴ substituiert sein können, oder eine Kombination dieser Systeme; dabei können zwei oder mehrere Substituenten R¹, R² und/oder R³ miteinander ein weiteres mono- oder polycyclisches, aliphatisches oder aromatisches Ringsystem aufspannen;
R⁴ ist bei jedem Auftreten gleich oderverschieden H, F, Cl, Br, I, CN, NO₂, eine geradkettige, verzweigte oder cyclische Alkyl- oder Alkoxykette mit 1 bis 22 C-Atomen, in der auch ein oder mehrere nicht benachbarte C-Atome durch -R⁵C=CR⁵-, -C≡C-, Si(R⁵)₂, Ge(R⁵)₂, Sn(R⁵)₂, -NR⁵-, -O-, -S-, -CO-O- oder -O-CO-O- ersetzt sein können, wobei auch ein oder mehrere H-Atome durch F, Cl, Br, I, CN, NO₂ ersetzt sein können, eine Aryl-, Heteroaryl- oder Aryloxygruppe mit 1 bis 40 C-Atomen, welche auch durch ein oder mehrere Reste R⁵ substituiert sein können, oder OH, N(R⁵)₂, B(R⁵)₂ oder Si(R⁵)₃;
R⁵ ist bei jedem Auftreten gleich oder verschieden H oder ein aliphatischer oder aromatischer Kohlenwasserstoffrest mit 1 bis 20 C-Atomen;
n ist bei jedem Auftreten gleich oder verschieden 1, 2, 3 oder 4;
p ist bei jedem Auftreten gleich oder verschieden 1, 2 oder 3;
die gestrichelte Bindung stellt die Anknüpfung an das Polymer dar;
und
(B) 0.01-50 mol% mindestens eines kovalent gebundenen Iridium-Komplexes, der aus dem Triplett-Zustand Licht emittiert.

2. Copolymere gemäß Anspruch 1, **dadurch gekennzeichnet, dass** X für eine Gruppe R³ steht und die Struktureinheit gemäß Formel (1) in die Seitenkette des Polymers gebunden ist.

3. Copolymere gemäß Anspruch 1, **dadurch gekennzeichnet, dass** X für eine bivalente Gruppe -(Y)ₚ- steht und die Struktureinheit gemäß Formel (1) über die beiden Gruppen Y in die Hauptkette des Polymers gebunden ist.

4. Copolymer gemäß einem oder mehreren der Ansprüche 1 bis 3, **dadurch gekennzeichnet, dass** der Iridium-Komplex in die Seitenkette des Polymers eingebaut ist.

5. Copolymer gemäß einem oder mehreren der Ansprüche 1 bis 3, **dadurch gekennzeichnet, dass** der Iridium-Komplex in die Hauptkette des Polymers eingebaut ist.

6. Copolymer gemäß einem oder mehreren der Ansprüche 1 bis 5, **dadurch gekennzeichnet, dass** es konjugiert oder teilkonjugiert ist.

7. Copolymer gemäß einem oder mehreren der Ansprüche 1 bis 6, **dadurch gekennzeichnet, dass** es außer Einheiten gemäß Formel (1) und außer dem Iridium-Komplex weitere Strukturelemente enthält.

8. Copolymer gemäß Anspruch 7, **dadurch gekennzeichnet, dass** die weiteren Struktureinheiten das Polymergrundgerüst bilden und/oder die Ladungsinjektions- bzw. Ladungstransporteigenschaften verbessern.

9. Copolymere gemäß einem oder mehreren der Ansprüche 1 bis 8, **dadurch gekennzeichnet, dass** das Symbol A, gleich oder verschieden bei jedem Auftreten für Si oder Ge steht.

10. Copolymere gemäß einem oder mehreren der Ansprüche 1 bis 9, **dadurch gekennzeichnet, dass** das Symbol Y, gleich oder verschieden bei jedem Auftreten, für ein aromatisches Ringsystem mit 2 bis 25 C-Atomen, das durch ein oder mehrere Reste R⁴ substituiert sein kann, eine Vinylengruppe -CR⁴=CR⁴- oder eine Acetylengruppe -C≡C- steht, mit der Maßgabe, dass eine Vinylengruppe oder eine Acetylengruppe nur an ein aromatisches System gebunden sein kann.

11. Copolymere gemäß einem oder mehreren der Ansprüche 1 bis 10, **dadurch gekennzeichnet, dass** die Symbole R¹, R², R³, gleich oder verschieden bei jedem Auftreten, wie unter Anspruch 1 definiert sind, wobei mindestens einer der Substituenten R¹ bis R³ ein aromatisches oder heteroaromatisches Ringsystem mit 2 bis 25 C-Atomen darstellt, das mit einem oder mehreren Substituenten R⁴ substituiert sein kann.

12. Copolymere gemäß einem oder mehreren der Ansprüche 1 bis 11, **dadurch gekennzeichnet, dass** der Index n, gleich oder verschieden bei jedem Auftreten 1, 2 oder 3 ist.

13. Copolymere gemäß einem oder mehreren der Ansprüche 1 bis 12, **dadurch gekennzeichnet, dass** der Index p, gleich oder verschieden bei jedem Auftreten 1 oder 3 ist.

14. Copolymere gemäß einem oder mehreren der Ansprüche 1 bis 13, **dadurch gekennzeichnet, dass** die Struktureinheiten gemäß Formel (1) symmetrisch aufgebaut sind.

15. Copolymere gemäß einem oder mehreren der Ansprüche 1 bis 14, **dadurch gekennzeichnet, dass** die Struktureinheiten gemäß Formel (1) aus den Beispielen (1) bis (27) ausgewählt sind,
| | | |
|---|---|---|
| 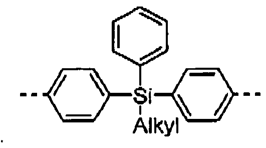 | 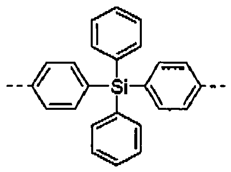 | 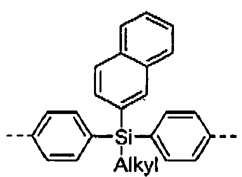 |
| Beispiel 1 | Beispiel 2 | Beispiel 3 |
| 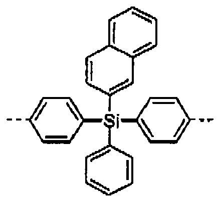 | 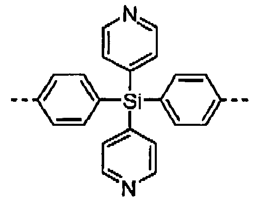 | 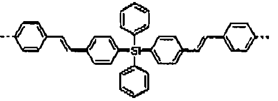 |
| Beispiel 4 | Beispiel 5 | Beispiel 6 |
| 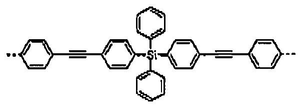 | 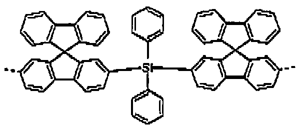 | 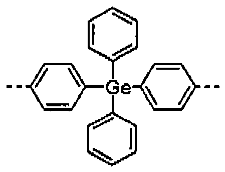 |
| Beispiel 7 | Beispiel 8 | Beispiel 9 |
| 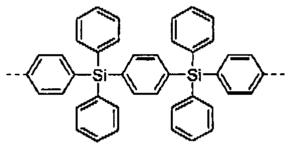 | 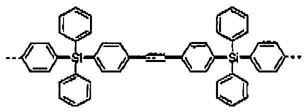 | 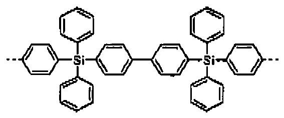 |
| Beispiel 10 | Beispiel 11 | Beispiel 12 |
| 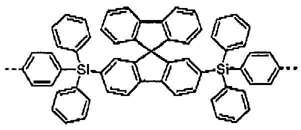 | 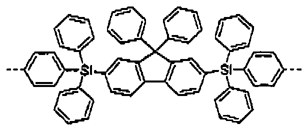 | 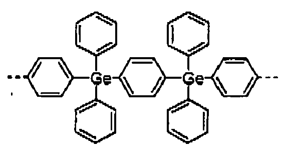 |
| Beispiel 13 | Beispiel 14 | Beispiel 15 |
| 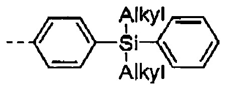 | 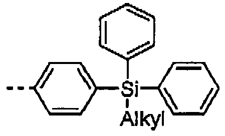 | 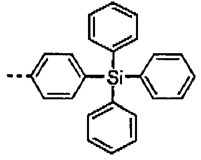 |
| Beispiel 16 | Beispiel 17 | Beispiel 18 |
| 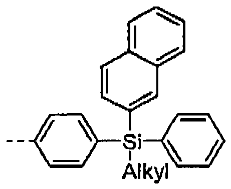 | 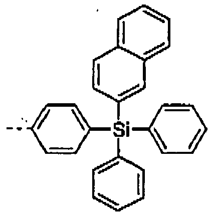 | 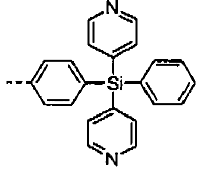 |
| Beispiel 19 | Beispiel 20 | Beispiel 21 |
| 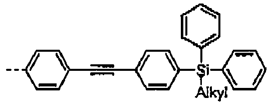 | 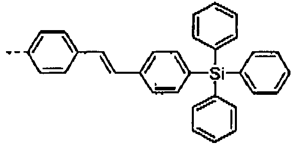 | 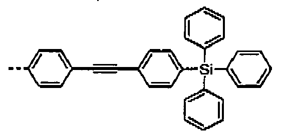 |
| Beispiel 22 | Beispiel 23 | Beispiel 24 |
| 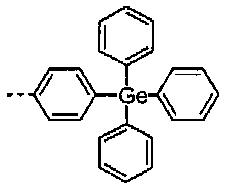 | 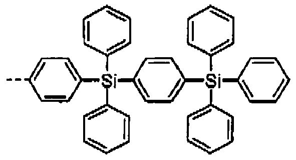 | 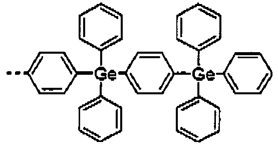 |
| Beispiel 25 | Beispiel 26 | Beispiel 27 |
die substituiert oder unsubstituiert sein können.

16. Copolymere gemäß einem oder mehreren der Ansprüche 1 bis 15, **dadurch gekennzeichnet, dass** sie 5-80 mol% Struktureinheiten gemäß Formel (1) enthalten.

17. Copolymer gemäß einem oder mehreren der Ansprüche 1 bis 16, **dadurch gekennzeichnet, dass** es sich um metallorganische Iridium-Komplexe handelt.

18. Copolymere gemäß einem oder mehreren der Ansprüche 1 bis 17, **dadurch gekennzeichnet, dass** die Iridium-Komplexe drei zweizähnig-chelatisierende Liganden enthalten.

19. Copolymere gemäß Anspruch 17 und 18, **dadurch gekennzeichnet, dass** die Iridium-Komplexe eine Struktur gemäß Formel (2) aufweisen: 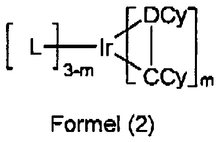 wobei R⁵ wie unter Anspruch 1 definiert ist und für die weiteren verwendeten Symbole gilt:
DCy ist bei jedem Auftreten gleich oder verschieden eine cyclische Gruppe, die mindestens ein Donoratom, bevorzugt Stickstoff oder Phosphor, enthält, über welches die cyclische Gruppe an das Iridium gebunden ist, und die wiederum einen oder mehrere Substituenten R⁶ tragen kann; die Gruppen DCy und CCy sind über eine kovalente Bindung miteinander verbunden;
CCy ist bei jedem Auftreten gleich oder verschieden eine cyclische Gruppe, die mindestens ein Kohlenstoffatom enthält, über welches die cyclischen Gruppe an das Iridium gebunden ist, und die wiederum einen oder mehrere Substituenten R⁶ tragen kann;
L ist bei jedem Auftreten gleich oder verschieden ein zweizähnig chelatisierender Ligand;
R⁶ ist bei jedem Auftreten gleich oder verschieden H, F, Cl, Br, I, NO₂, CN, eine geradkettige oder verzweigte oder cyclische Alkyl- oder Alkoxygruppe mit 1 bis 40 C-Atomen, wobei ein oder mehrere nicht benachbarte CH₂-Gruppen durch C=O, C=S, C=Se, C=NR⁵, -R⁵C=CR⁵-, -C≡C-, -O-, -S-, -NR⁵-, Si(R⁵)₂ oder -CONR⁵- ersetzt sein können und wobei ein oder mehrere H-Atome durch F, Cl, Br, I, CN, NO₂ ersetzt sein können, oder ein aromatisches oder heteroaromatisches Ringsystem mit 2 bis 40 C-Atomen, das durch einen oder mehrere, nicht-aromatische Reste R⁶ substituiert sein kann; wobei mehrere Substituenten R⁶, sowohl am selben Ring als auch an den beiden unterschiedlichen Ringen zusammen wiederum ein weiteres mono- oder polycyclisches, aliphatisches oder aromatisches Ringsystem aufspannen können;
m ist bei jedem Auftreten 1, 2 oder 3;
dabei erfolgt die Anknüpfung an das Polymer entweder über einen oder über mehrere Liganden.

20. Copolymere gemäß Anspruch 19, **dadurch gekennzeichnet, dass** der Ligand L ein monoanionischer Ligand ist, ausgesucht aus der Gruppe der 1,3-Diketonate abgeleitet von 1,3-Diketonen, 3-Ketonate abgeleitet von 3-Ketoestern,
Carboxylate abgeleitet von Aminocarbonsäuren oder Salicyliminate abgeleitet von Salicyliminen.

21. Copolymere gemäß einem oder mehreren der Ansprüche 1 bis 20, **dadurch gekennzeichnet, dass** der Anteil der Iridium-Komplexe im Polymer 1 - 25 mol% beträgt.

22. Mischungen (Blends) aus mindestens einem Copolymer gemäß einem oder mehreren der Ansprüche 1 bis 21 mit einem oder mehreren konjugierten, teilkonjugierten oder nicht-konjugierten Polymeren, Oligomeren, Dendrimeren oder niedermolekularen Verbindungen.

23. Verwendung eines Copolymers gemäß einem oder mehreren der Ansprüche 1 bis 22 in einer organischen elektronischen Vorrichtung.

24. Organische elektronische Vorrichtung mit einer oder mehreren Schichten, wobei mindestens eine dieser Schichten mindestens ein Copolymer oder eine Mischung gemäß einem oder mehreren der Ansprüche 1 bis 22 enthält.

25. Organische elektronische Vorrichtung gemäß Anspruch 24, **dadurch gekennzeichnet, dass** es sich um organische Leuchtdioden (PLED), organische Solarzellen (O-SCs), nicht-lineare optische Vorrichtungen, Frequenzverdopplung (Up-conversion), organische optische Detektoren, organische Feld-Quench-Devices (O-FQDs) oder organische Laserdioden (O-Laser) handelt.

## Claims

1. Copolymers containing
(A) 1 - 99.99 mol% of at least one structural unit of the formula (1), 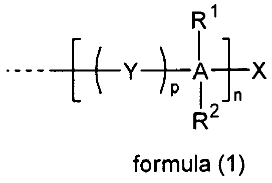 where the following applies to the symbols and indices used:
A is on each occurrence, identically or differently, Si, Ge, Sn or Pb;
Y is on each occurrence, identically or differently, a divalent aromatic or heteroaromatic ring system having 1 to 40 C atoms, which may be substituted by one or more radicals R⁴, a vinylene group -CR⁴=CR⁴- or an acetylene group -C≡C-;
X is on each occurrence, identically or differently, a divalent group -(Y)ₚ- or a monovalent group R³;
R¹, R², R³ are on each occurrence, identically or differently, H, F, CN, N(R⁴)₂, a straight-chain, branched or cyclic alkyl, alkoxy or thioalkoxy group having 1 to 40 C atoms, which may be substituted by R⁴ or also unsubstituted, where one or more non-adjacent CH₂ groups may be replaced by -R⁵C=CR⁵-, -C≡C-, Si(R⁵)₂, Ge(R⁵)₂, Sn(R⁵)₂, C=O, C=S, C=Se, C=NR⁵, -O-, -S-, -NR⁵- or -CONR⁵- and where one or more H atoms may be replaced by F, Cl, Br, I, CN, OH or NO₂, or an aromatic or heteroaromatic ring system or an aryloxy or heteroaryloxy group, each having 2 to 40 aromatic C atoms, each of which may be substituted by one or more radicals R⁴, or a combination of these systems; two or more substituents R¹, R² and/or R³ here may form a further mono- or polycyclic, aliphatic or aromatic ring system with one another;
R⁴ is on each occurrence, identically or differently, H, F, Cl, Br, I, CN, NO₂, a straight-chain, branched or cyclic alkyl or alkoxy chain having 1 to 22 C atoms, in which, in addition, one or more non-adjacent C atoms may be replaced by -R⁵C=CR⁵-, -C≡C-, Si(R⁵)₂, Ge(R⁵)₂, Sn(R⁵)_{2,} -NR⁵-, -O-, -S-, -CO-O- or -O-CO-O- and where one or more H atoms may be replaced by F, Cl, Br, I, CN or NO₂, an aryl, heteroaryl or aryloxy group having 1 to 40 C atoms, which, in addi- tion, may be substituted by one or more radicals R⁵, or OH, N(R⁵)₂, B(R⁵)₂ or Si(R⁵)₃;
R⁵ is on each occurrence, identically or differently, H or an aliphatic or aromatic hydrocarbon radical having 1 to 20 C atoms;
n is on each occurrence, identically or differently, 1, 2, 3 or 4;
p is on each occurrence, identically or differently, 1, 2 or 3;
the dashed bond represents the link to the polymer;
and
(B) 0.01 - 50 mol% of at least one covalently bonded iridium complex which emits light from the triplet state.

2. Copolymers according to Claim 1, **characterised in that** X stands for a group R³, and the structural unit of the formula (1) is bonded into the side chain of the polymer.

3. Copolymers according to Claim 1, **characterised in that** X stands for a divalent group -(Y)p-, and the structural unit of the formula (1) is bonded into the main chain of the polymer via the two groups Y.

4. Copolymer according to one or more of Claims 1 to 3, **characterised in that** the iridium complex is incorporated into the side chain of the polymer.

5. Copolymer according to one or more of Claims 1 to 3, **characterised in that** the iridium complex is incorporated into the main chain of the polymer.

6. Copolymer according to one or more of Claims 1 to 5, **characterised in that** it is conjugated or partially conjugated.

7. Copolymer according to one or more of Claims 1 to 6, **characterised in that** it contains further structural elements in addition to units of the formula (1) and in addition to the iridium complex.

8. Copolymer according to Claim 7, **characterised in that** the further structural units form the polymer backbone and/or improve the charge-injection or charge-transport properties.

9. Copolymers according to one or more of Claims 1 to 8, **characterised in that** the symbol A, identically or differently on each occurrence, stands for Si or Ge.

10. Copolymers according to one or more of Claims 1 to 9, **characterised in that** the symbol Y, identically or differently on each occurrence, stands for an aromatic ring system having 2 to 25 C atoms, which may be substituted by one or more radicals R⁴, a vinylene group -CR⁴=CR⁴- or an acetylene group -C≡C-, with the proviso that a vinylene group or an acetylene group may only be bonded to an aromatic system.

11. Copolymers according to one or more of Claims 1 to 10, **characterised in that** the symbols R¹, R², R³, identically or differently on each occurrence, are as defined under Claim 1, where at least one of the substituents R¹ to R³ represents an aromatic or heteroaromatic ring system having 2 to 25 C atoms, which may be substituted by one or more substituents R⁴.

12. Copolymers according to one or more of Claims 1 to 11, **characterised in that** the index n, identically or differently on each occurrence, is 1, 2 or 3.

13. Copolymers according to one or more of Claims 1 to 12, **characterised in that** the index p, identically or differently on each occurrence, is 1 or 3.

14. Copolymers according to one or more of Claims 1 to 13, **characterised in that** the structural units of the formula (1) have a symmetrical structure.

15. Copolymers according to one or more of Claims 1 to 14, **characterised in that** the structural units of the formula (1) are selected from Examples (1) to (27),
| | | |
|---|---|---|
| 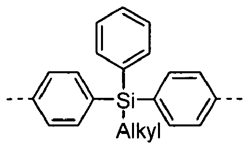 | 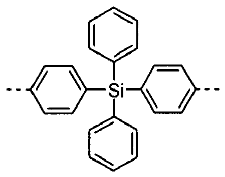 | 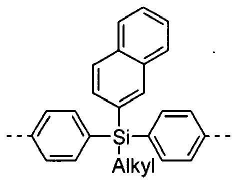 |
| Example 1 | Example 2 | Example 3 |
| 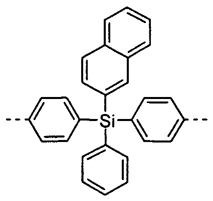 | 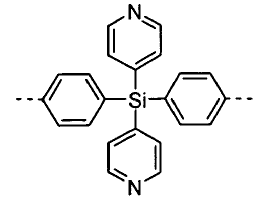 | 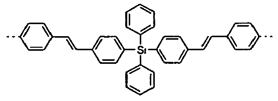 |
| Example 4 | Example 5 | Example 6 |
| 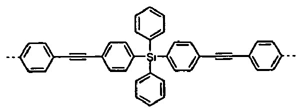 | 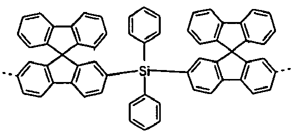 | 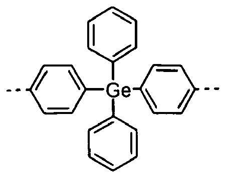 |
| Example 7 | Example 8 | Example 9 |
| 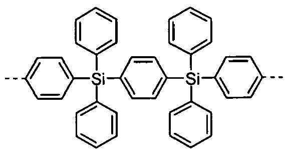 | 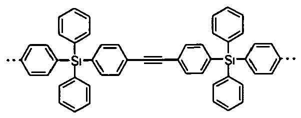 | 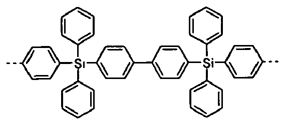 |
| Example 10 | Example 11 | Example 12 |
| 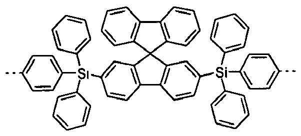 | 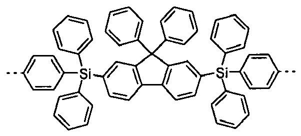 | 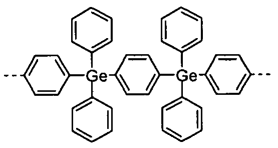 |
| Example 13 | Example 14 | Example 15 |
| 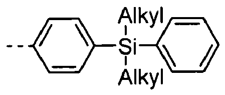 | 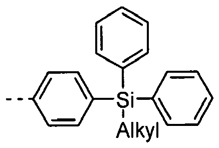 | 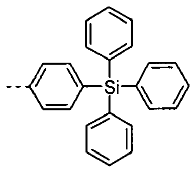 |
| Example 16 | Example 17 | Example 18 |
| 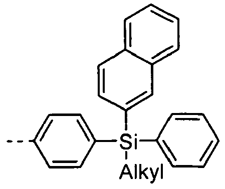 | 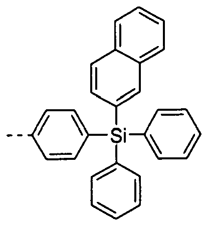 | 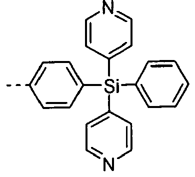 |
| Example 19 | Example 20 | Example 21 |
| 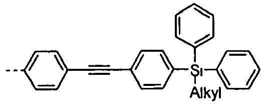 | 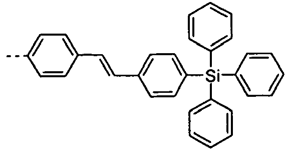 | 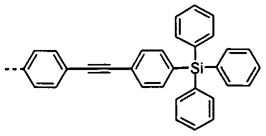 |
| Example 22 | Example 23 | Example 24 |
| 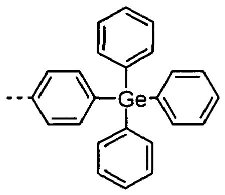 | 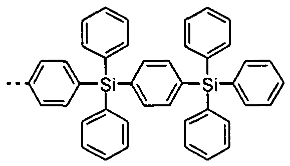 | 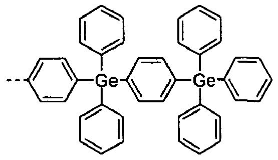 |
| Example 25 | Example 26 | Example 27 |
which may be substituted or unsubstituted.

16. Copolymers according to one or more of Claims 1 to 15, **characterised in that** they contain 5-80 mol% of structural units of the formula (1).

17. Copolymers according to one or more of Claims 1 to 16, **characterised in that** they are organometallic iridium complexes.

18. Copolymers according to one or more of Claims 1 to 17, **characterised in that** the iridium complexes contain three bidentate-chelating ligands.

19. Copolymers according to Claims 17 and 18, **characterised in that** the iridium complexes have a structure in accordance with formula (2): 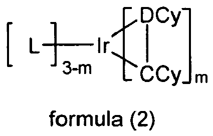 where R⁵ is as defined under Claim 1, and the following applies to the other symbols used:
DCy is on each occurrence, identically or differently, a cyclic group which contains at least one donor atom, preferably nitrogen or phosphorus, via which the cyclic group is bonded to the iridium and which may in turn carry one or more substituents R⁶; the groups DCy and CCy are bonded to one another via a covalent bond;
CCy is on each occurrence, identically or differently, a cyclic group which contains at least one carbon atom via which the cyclic group is bonded to the iridium and which may in turn carry one or more substituents R⁶;
L is on each occurrence, identically or differently, a bidentate-chelating ligand;
R⁶ is on each occurrence, identically or differently, H, F, Cl, Br, I, NO₂, CN, a straight-chain or branched or cyclic alkyl or alkoxy group having 1 to 40 C atoms, where one or more non-adjacent CH₂ groups may be replaced by C=O, C=S, C=Se, C=NR⁵, -R⁵C=CR⁵-, -C≡C-, -O-, -S-, -NR⁵-, Si(R⁵)₂ or -CONR⁵- and where one or more H atoms may be replaced by F, Cl, Br, I, CN or NO₂, or an aromatic or heteroaromatic ring system having 2 to 40 C atoms, which may be substituted by one or more non-aromatic radicals R⁶; where a plurality of substituents R⁶, both on the same ring and also on the two different rings, may together in turn form a further mono- or polycyclic, aliphatic or aromatic ring system;
m is on each occurrence 1, 2 or 3;
the linking to the polymer takes place here either via one or via a plurality of ligands.

20. Copolymers according to Claim 19, **characterised in that** the ligand L is a monoanionic ligand selected from the group of the 1,3-diketonates derived from 1,3-diketones, 3-ketonates derived from 3-ketoesters, carboxylates derived from aminocarboxylic acids or salicyliminates derived from salicylimines.

21. Copolymers according to one or more of Claims 1 to 20, **characterised in that** the proportion of the iridium complexes in the polymer is 1 - 25 mol%.

22. Mixtures (blends) of at least one copolymer according to one or more of Claims 1 to 21 with one or more conjugated, partially conjugated or non-conjugated polymers, oligomers, dendrimers or low-molecular-weight compounds.

23. Use of a copolymer according to one or more of Claims 1 to 22 in an organic electronic device.

24. Organic electronic device having one or more layers, where at least one of these layers comprises at least one copolymer or a mixture according to one or more of Claims 1 to 22.

25. Organic electronic device according to Claim 24, **characterised in that** it relates to organic light-emitting diodes (PLEDs), organic solar cells (O-SCs), non-linear optical devices, frequency doubling (upconversion), organic optical detectors, organic field-quench devices (O-FQDs) or organic laser diodes (O-lasers).

## Revendications

1. Copolymères contenant
(A) 1-99,99 mol% d'au moins une unité structurelle de la formule (1), 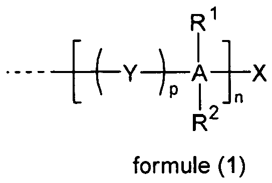 dans laquelle ce qui suit s'applique aux symboles et indices utilisés :
A est, pour chaque occurrence, de manière identique ou différente, Si, Ge, Sn ou Pb ;
Y est, pour chaque occurrence, de manière identique ou différente, un système de cycle aromatique ou hétéroaromatique divalent comportant de 1 à 40 atomes de C, lesquels peuvent être substitués par un ou plusieurs radicaux R⁴, un groupe vinylène -CR⁴=CR⁴- ou un groupe acétylène -C≡C- ;
X est, pour chaque occurrence, de manière identique ou différente, un groupe divalent -(Y)ₚ- ou un groupe monovalent R³ ;
R¹, R², R³ sont, pour chaque occurrence, de manière identique ou différente, H, F, CN, N(R⁴)₂, un groupe alkyle, alcoxy ou thioalcoxy en chaîne droite, ramifié ou cyclique comportant de 1 à 40 atomes de C, lesquels peuvent être substitués par R⁴ ou également non substitué, où un ou plusieurs groupes CH₂ non adjacents peut/peuvent être remplacé(s) par -R⁵C=CR⁵-, -C≡C-, Si(R⁵)₂, Ge(R⁵)₂, Sn(R⁵)₂, C=O, C=S, C=Se, C=NR⁵, -O-, -S-, -NR⁵- ou -CONR⁵- et où un ou plusieurs atomes de H peut/peuvent être remplacé(s) par F, Cl, Br, I, CN, OH ou NO₂, ou un système de cycle aromatique ou hétéroaromatique ou un groupe aryloxy ou hétéroaryloxy, chacun comportant de 2 à 40 atomes de C aromatiques, dont chacun peut être substitué par un ou plusieurs radicaux R⁴, ou une combinaison de ces systèmes ; deux substituents R¹, R² et/ou R³ ou plus peuvent ici former un autre système de cycle aliphatique ou aromatique monocyclique ou polycyclique, l'un avec l'autre;
R⁴ est, pour chaque occurrence, de manière identique ou différente, H, F, Cl, Br, I, CN, NO₂, une chaîne alkyle ou alcoxy en chaîne droite, ramifiée ou cyclique comportant de 1 à 22 atomes de C, où, en outre, un ou plusieurs atomes de C non adjacents peut/peuvent être remplacé(s) par -R⁵C=CR⁵-, -C≡C-, Si(R⁵)₂, Gₑ(R⁵)₂, Sₙ(R⁵)₂, -NR⁵-, -O-, -S-, -CO-O- ou -O-CO-O- et où un ou plusieurs atomes de H peut/peuvent être remplacé(s) par F, Cl, Br, I, CN ou NO₂, un groupe aryle, hétéroaryle ou aryloxy comportant de 1 à 40 atomes de C, lesquels, en outre, peuvent être substitués par un ou plusieurs radicaux R⁵, ou OH, N(R⁵)₂, B(R⁵)₂ ou Si(R⁵)₃ ;
R⁵ est, pour chaque occurrence, de manière identique ou différente, H ou un radical hydrocarbone aliphatique ou aromatique comportant de 1 à 20 atomes de C ;
n est, pour chaque occurrence, de manière identique ou différente, 1, 2, 3 ou 4;
p est, pour chaque occurrence, de manière identique ou différente, 1, 2 ou 3 ;
la liaison en pointillés représente le lien sur le polymère ;
et
(B) 0,01 - 50 mol% d'au moins un complexe d'iridium lié de façon covalente, lequel émet de la lumière depuis l'état triplet.

2. Copolymères selon la revendication 1, **caractérisés en ce que** X représente un groupe R³, et l'unité structurelle de la formule (1) est liée dans la chaîne latérale du polymère.

3. Copolymères selon la revendication 1, **caractérisés en ce que** X représente un groupe divalent -(Y)ₚ-, et l'unité structurelle de la formule (1) est liée dans la chaîne principale du polymère via les deux groupes Y.

4. Copolymère selon les revendications 1 à 3, **caractérisé en ce que** le complexe d'iridium est incorporé dans la chaîne latérale du polymère.

5. Copolymère selon une ou plusieurs des revendications 1 à 3, **caractérisé en ce que** le complexe d'iridium est incorporé dans la chaîne principale du polymère.

6. Copolymère selon une ou plusieurs des revendications 1 à 5, **caractérisé en ce qu'**il est conjugué ou partiellement conjugué.

7. Copolymère selon une ou plusieurs des revendications 1 à 6, **caractérisé en ce qu'**il contient d'autres éléments structurels en plus des unités de la formule (1) et en plus du complexe d'iridium.

8. Copolymère selon la revendication 7, **caractérisé en ce que** les autres unités structurelles forment l'ossature de polymère et/ou améliorent les propriétés d'injection de charges ou de transport de charges.

9. Copolymères selon une ou plusieurs des revendications 1 à 8, **caractérisés en ce que** le symbole A, de manière identique ou différente pour chaque occurrence, représente Si ou Ge.

10. Copolymères selon une ou plusieurs revendications 1 à 9, **caractérisés en ce que** le symbole Y, de manière identique ou différente pour chaque occurrence, représente un système de cycle aromatique comportant de 2 à 25 atomes de C, lesquels peuvent être substitués par un ou plusieurs radicaux R⁴, un groupe vinylène -CR⁴=CR⁴- ou un groupe acétylène -C≡C-, étant entendu qu'un groupe vinylène ou un groupe acétylène peut seulement être lié à un système aromatique.

11. Copolymères selon une ou plusieurs des revendications 1 à 10, **caractérisés en ce que** les symboles R¹, R², R³, de manière identique ou différente pour chaque occurrence, sont comme défini sous la revendication 1, où au moins l'un des substituents R¹ à R³ représente un système de cycle aromatique ou hétéroaromatique comportant de 2 à 25 atomes de C, lesquels peuvent être substitués par un ou plusieurs substituents R⁴.

12. Copolymères selon une ou plusieurs des revendications 1 à 11, **caractérisés en ce que** l'indice n, de manière identique ou différente pour chaque occurrence, est 1, 2 ou 3.

13. Copolymères selon une ou plusieurs des revendications 1 à 12, **caractérisés en ce que** l'indice p, de manière identique ou différente pour chaque occurrence, est 1 ou 3.

14. Copolymères selon une ou plusieurs des revendications 1 à 13, **caractérisés en ce que** les unités structurelles de la formule (1) présentent une structure symétrique.

15. Copolymères selon une ou plusieurs des revendications 1 à 14, **caractérisés en ce que** les unités structurelles de la formule (1) sont choisies parmi les exemples (1) à (27),
| | | |
|---|---|---|
| 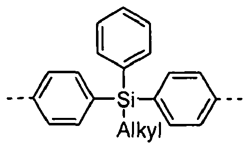 | 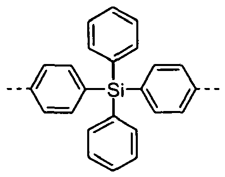 | 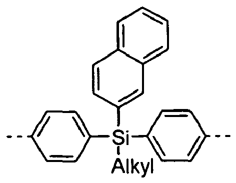 |
| Exemple 1 | Exemple 2 | Exemple 3 |
| 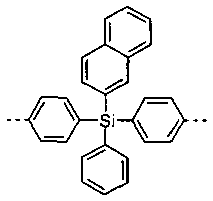 | 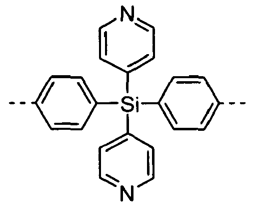 | 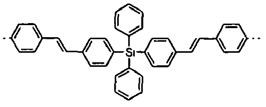 |
| Exemple 4 | Exemple 5 | Exemple 6 |
| 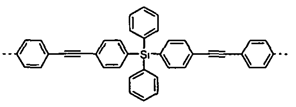 | 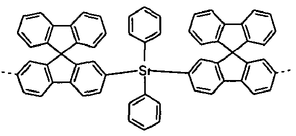 | 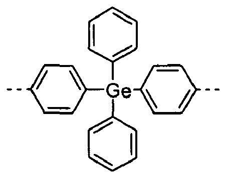 |
| Exemple 7 | Exemple 8 | Exemple 9 |
| 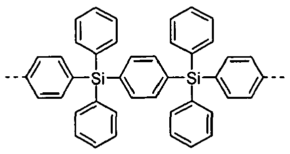 | 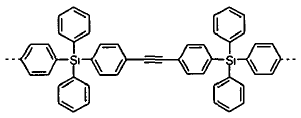 | 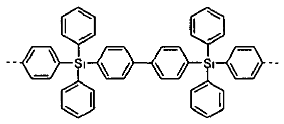 |
| Exemple 10 | Exemple 11 | Exemple 12 |
| 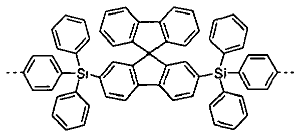 | 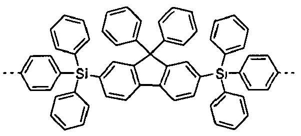 | 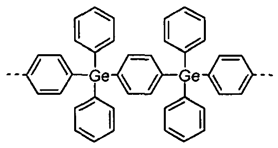 |
| Exemple 13 | Exemple 14 | Exemple 15 |
| 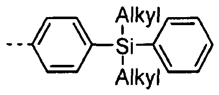 | 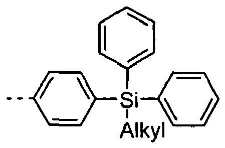 | 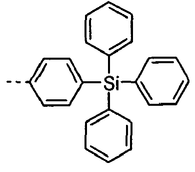 |
| Exemple 16 | Exemple 17 | Exemple 18 |
| 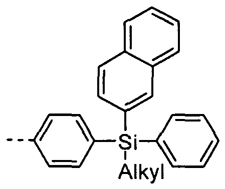 | 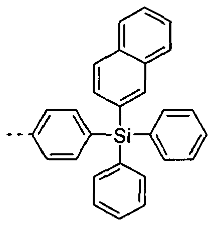 | 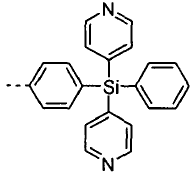 |
| Exemple 19 | Exemple 20 | Exemple 21 |
| 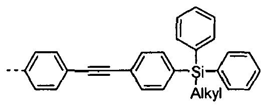 | 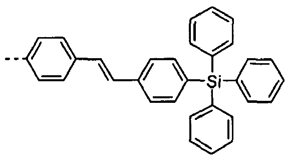 | 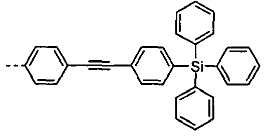 |
| Exemple 22 | Exemple 23 | Exemple 24 |
| 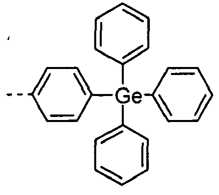 | 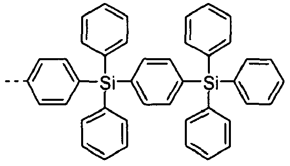 | 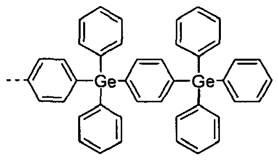 |
| Exemple 25 | Exemple 26 | Exemple 27 |
lesquelles unités peuvent être substituées ou non substituées.

16. Copolymères selon une ou plusieurs des revendications 1 à 15, **caractérisés en ce qu'**ils contiennent 5-80 mol% d'unités structurelles de la formule (1).

17. Copolymères selon une ou plusieurs des revendications 1 à 16, **caractérisés en ce que** ce sont des complexes d'iridium organométalliques.

18. Copolymères selon une ou plusieurs des revendications 1 à 17, **caractérisés en ce que** les complexes d'iridium contiennent trois ligands chélatants bidentés.

19. Copolymères selon les revendications 17 et 18, **caractérisés en ce que** les complexes d'iridium présentent une structure conformément à la formule (2): 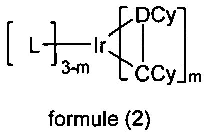 dans laquelle R⁵ est comme défini sous la revendication 1, et ce qui suit s'applique aux autres symboles utilisés :
DCy est, pour chaque occurrence, de manière identique ou différente, un groupe cyclique qui contient au moins un atome de donneur, de préférence azote ou phosphore, via lequel le groupe cyclique est lié à l'iridium et qui peut à son tour supporter un ou plusieurs substituents R⁶ ; les groupes DCy et CCy sont liés l'un à l'autre via une liaison covalente ;
CCy est, pour chaque occurrence, de manière identique ou différente, un groupe cyclique qui contient au moins un atome de carbone via lequel le groupe cyclique est lié à l'iridium et qui peut à son tour supporter un ou plusieurs substituents R⁶ ;
L est, pour chaque occurrence, de manière identique ou différente, un ligand chélatant bidenté ;
R⁶ est, pour chaque occurrence, de manière identique ou différente, H, F, Cl, Br, I, NO₂, CN, un groupe alkyle ou alcoxy cyclique en chaîne droite ou ramifié comportant de 1 à 40 atomes de C, où un ou plusieurs groupes CH₂ non adjacents peut/peuvent être remplacé(s) par C=O, C=S, C=Se, C=NR⁵, -R⁵C=CR⁵-, -C≡C-, -O-, -S-, -NR⁵-, Si(R⁵)₂ ou -CONR⁵- et où un ou plusieurs atomes de H peut/peuvent être remplacé(s) par F, Cl, Br, I, CN ou NO₂, ou un système de cycle aromatique ou hétéroaromatique comportant de 2 à 40 atomes de C, lesquels peuvent être substitués par un ou plusieurs radicaux R⁶ non aromatiques ; où une pluralité de substituents R⁶, à la fois sur le même cycle et également sur les deux cycles différents, peuvent ensemble à leur tour former un autre système de cycle monocyclique ou polycyclique, aliphatique ou aromatique ;
m est, pour chaque occurrence 1, 2 ou 3 ;
le lien sur le polymère est réalisé ici soit via un ligand, soit via une pluralité de ligands.

20. Copolymères selon la revendication 19, **caractérisé en ce que** le ligand L est un ligand monoanionique choisi parmi le groupe des 1,3-dicétonates dérivés des 1,3-dicétones, des 3-cétonates dérivés des 3-cétoesters, des carboxylates dérivés des acides aminocarboxyliques ou des salicyliminates dérivés des salicylimines.

21. Copolymères selon une ou plusieurs des revendications 1 à 20, **caractérisés en ce que** la proportion des complexes d'iridium complexes dans le polymère est de 1 - 25 mol%.

22. Mélanges (blends) d'au moins un copolymère selon une ou plusieurs des revendications 1 à 21 avec un ou plusieurs polymères, oligomères ou composés de poids moléculaire faible conjugués, partiellement conjugués ou non conjugués.

23. Utilisation d'un copolymère selon une ou plusieurs des revendications 1 à 22 dans un dispositif électronique organique.

24. Dispositif électronique organique comportant une ou plusieurs couches, où au moins l'une de ces couches comprend au moins un copolymère ou un mélange selon une ou plusieurs des revendications 1 à 22.

25. Dispositif électronique organique selon la revendication 24, **caractérisé en ce qu'**il concerne des diodes émettrices de lumière organiques (PLED), des cellules solaires organiques (O-SC), des dispositifs optiques non linéaires, un doublage de fréquence (conversion élévatrice), des détecteurs optiques organiques, des dispositifs d'extinction de champ organiques (O-FQD) ou des diodes laser organiques (O-laser).
